(19) Europäisches Patentamt / European Patent Office / Office européen des brevets

(11) **EP 4 333 310 B1**

(12) **EUROPEAN PATENT SPECIFICATION**

(45) Date of publication and mention of the grant of the patent:
**29.10.2025 Bulletin 2025/44**

(51) International Patent Classification (IPC):
**H03M 13/29** *(2006.01)*   **H03M 13/27** *(2006.01)*
**H03M 13/03** *(2006.01)*   **G06N 3/0455** *(2023.01)*
**G06N 3/08** *(2023.01)*   **H03M 13/00** *(2006.01)*
**G06N 3/048** *(2023.01)*

(21) Application number: **23194604.7**

(22) Date of filing: **31.08.2023**

(52) Cooperative Patent Classification (CPC):
**H03M 13/2927; G06N 3/0455; G06N 3/08; H03M 13/036; H03M 13/2707; H03M 13/2906; H03M 13/6597; G06N 3/048**

(54) **METHODS AND SYSTEMS FOR DATA TRANSFER VIA A COMMUNICATION CHANNEL**

VERFAHREN UND SYSTEME ZUR DATENÜBERTRAGUNG ÜBER EINEN KOMMUNIKATIONSKANAL

PROCÉDÉS ET SYSTÈMES DE TRANSFERT DE DONNÉES PAR L'INTERMÉDIAIRE D'UN CANAL DE COMMUNICATION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.08.2022 LU 502737**

(43) Date of publication of application:
**06.03.2024 Bulletin 2024/10**

(73) Proprietor: **Technische Universität Dresden**
**01069 Dresden (DE)**

(72) Inventors:
• **GÜNLÜ, Onur**
  **582 26 Linköping (SE)**
• **FRITSCHEK, Rick**
  **10559 Berlin (DE)**
• **SCHAEFER, Rafael Felix**
  **12209 Berlin (DE)**

(74) Representative: **Viering, Jentschura & Partner mbB**
**Patent- und Rechtsanwälte**
**Am Brauhaus 8**
**01099 Dresden (DE)**

(56) References cited:
US-B1- 11 387 848

• ONUR G�NL� ET AL: "Concatenated Classic and Neural (CCN) Codes: ConcatenatedAE", ARXIV.ORG, CORNELL UNIVERSITY LIBRARY, 201 OLIN LIBRARY CORNELL UNIVERSITY ITHACA, NY 14853, 4 September 2022 (2022-09-04), XP091310609
• JANNIS CLAUSIUS ET AL: "Serial vs. Parallel Turbo-Autoencoders and Accelerated Training for Learned Channel Codes", ARXIV.ORG, CORNELL UNIVERSITY LIBRARY, 201 OLIN LIBRARY CORNELL UNIVERSITY ITHACA, NY 14853, 22 July 2021 (2021-07-22), XP091004348
• CHAHINE KARL ET AL: "Turbo Autoencoder with a Trainable Interleaver", PROC., IEEE INTERNATIONAL CONFERENCE ON COMMUNICATIONS, IEEE, ICC-2022, 16 May 2022 (2022-05-16), pages 3886 - 3891, XP034167564, DOI: 10.1109/ICC45855.2022.9839051
• TOBIAS GRUBER ET AL: "On Deep Learning-Based Channel Decoding", ARXIV.ORG, CORNELL UNIVERSITY LIBRARY, 201 OLIN LIBRARY CORNELL UNIVERSITY ITHACA, NY 14853, 26 January 2017 (2017-01-26), XP080751805, DOI: 10.1109/CISS.2017.7926071

EP 4 333 310 B1

**Description**

**Technical Field**

The present disclosure refers to methods and systems for data transfer via a communication channel.

**Background**

Practical channel codes are necessary to reliably reconstruct messages that are transmitted through a noisy and/or nonlinear medium, such as air or an optical fiber, with a low complexity decoder that achieves small block error probabilities (BLER) and high code rates at specified blocklengths (S. Lin and D. J. Costello, Error control coding. Prentice Hall, 2001, vol. 2, no. 4). Capacity-achieving polar codes (E. Arikan, IEEE Trans. Inf. Theory, vol. 55, no. 7, pp. 3051-3073, 2009) are the first practical channel codes that are asymptotically optimal for binary-input memoryless symmetric channels. However, practical code design even for such channels, for which capacity-achieving and capacity-approaching codes are known, requires a careful adaptation of encoder-decoder pairs for different blocklengths, code rates, channel parameters, and complexity constraints (I. Tal and A. Vardy, IEEE Trans. Inf. Theory, vol. 61, no. 5, pp. 2213-2226, 2015). Furthermore, a change in the channel model, especially to a non-standard one, can significantly deteriorate the reliability performance of a practical code designed for a given model, which necessitates the automation of the code design procedure.

(Deep) artificial neural networks have been proposed as alternative encoder-decoder pairs used for error correction such that code design is automated with the aim of adapting to the changes in the channel model and code parameters and of improving on classic channel codes in terms of BLER and complexity (Y. Jiang et al., Conf. Neural Inf. Process. Sys., vol. 32, 2019, pp. 1-19; J. Clausius, et al., Int. Symp. Topics Coding, Montreal, 2021, pp. 1-5.). Such code constructions aim to design all component codes as neural networks.

Clausius, Jannis, et al. "Serial vs. parallel turbo-autoencoders and accelerated training for learned channel codes." 2021 11th International Symposium on Topics in Coding (ISTC). IEEE, 2021 describes Turbo-autoencoders for end-to-end learning of PHY-Layer communications.

US 11 387 848 B1 describes a controller hierarchical decoding architecture, in which multiple decoder hierarchies are implemented along with use of hierarchies of codes with locality (e.g., larger code length of a hierarchy is composed of local codes from a lower hierarchy).

Chahine, Karl, et al. "Turbo autoencoder with a trainable interleaver." ICC 2022-IEEE International Conference on Communications. IEEE, 2022 describes the application of the idea of Turbo Autoencoder to various practical channels, such as fading channels and chirp noise channels.

Gruber, Tobias, et al. "On deep learning-based channel decoding." 2017 51st annual conference on information sciences and systems (CISS). IEEE, 2017 describes a revisitation of the idea of using deep neural networks for one-shot decoding of random and structured codes, such as polar codes.

**Summary**

It is an object of the present disclosure to provide a method and a system for data transfer via a communication channel with an improved error rate and robustness properties. As a solution, methods and systems for data transfer via a communication channel according to the independent claims are provided.

According to one aspect, a method for data transfer via a communication channel is provided. The method comprises determining, in a first data processing unit, a codeword from a message using a channel code and sending the codeword via the communication channel. The channel code comprises an outer code concatenated with an inner code; the outer code is one of a Reed-Solomon code, a folded Reed-Solomon code, a twisted Reed-Solomon code, and a generalized Reed-Solomon code; the inner code is a neural network code comprising a neural encoder-decoder pair which includes an encoding neural network and a decoding neural network; a nonlinear channel and/or a noisy channel is arranged between the encoding neural network and the decoding neural network; the neural encoder-decoder pair has been adapted such that the decoding neural network provides an estimated outer codeword symbol for an input outer codeword symbol by training the neural encoder-decoder pair using a training data set which comprises a plurality of outer codewords determined from a plurality of input messages by an outer code encoder. Each outer codeword symbols of the plurality of outer codewords is used as an input to the encoding neural network.

According to another aspect, a method for data transfer via a communication channel is provided. The method comprises receiving, in a second data processing unit, a noisy version of a codeword that has been transmitted via the communication channel and determining an estimated message from the noisy version of the codeword using a channel code. The channel code comprises an outer code concatenated with an inner code; the outer code is one of a Reed-Solomon code, a folded Reed-Solomon code, a twisted Reed-Solomon code, and a generalized Reed-Solomon code; the inner code is a neural network code comprising a neural encoder-decoder pair which includes an encoding neural network and a decoding neural network; a nonlinear channel and/or a noisy channel is arranged between the encoding neural network and the decoding neural network; the neural encoder-decoder pair has been adapted such that the decoding neural network provides an estimated outer codeword symbol for an input outer codeword symbol by training the neural encoder-decoder pair using a training data set which comprises a plurality of outer codewords determined from a plurality of input messages by an outer code encoder. Each outer codeword symbols of the plurality of outer codewords is used as an input to the encoding neural network.

According to a further aspect, a system for data transfer via a communication channel is provided. The system comprises a first data processing unit and is configured to determine, in the first data processing unit, a codeword from a message using a channel code and to send the codeword via the communication channel. The channel code comprises an outer code concatenated with an inner code; the outer code is one of a Reed-Solomon code, a folded Reed-Solomon code, a twisted Reed-Solomon code, and a generalized Reed-Solomon code; the inner code is a neural network code comprising a neural encoder-decoder pair which includes an encoding neural network and a decoding neural network; a nonlinear channel and/or a noisy channel is arranged between the encoding neural network and the decoding neural network; the neural encoder-decoder pair has been adapted such that the decoding neural network provides an estimated outer codeword symbol for an input outer codeword symbol by training the neural encoder-decoder pair using a training data set which comprises a plurality of outer codewords determined from a plurality of input messages by an outer code encoder. Each outer codeword symbols of the plurality of outer codewords is used as an input to the encoding neural network.

According to another aspect, a system for data transfer via a communication channel is provided. The system comprises a second data processing unit and is configured to receive, in the second data processing unit, a noisy version of a codeword that has been transmitted via the communication channel and to determine an estimated message from the noisy version of the codeword using a channel code. The channel code comprises an outer code concatenated with an inner code; the outer code is one of a Reed-Solomon code, a folded Reed-Solomon code, a twisted Reed-Solomon code, and a generalized Reed-Solomon code; the inner code is a neural network code comprising a neural encoder-decoder pair which includes an encoding neural network and a decoding neural network; a nonlinear channel and/or a noisy channel is arranged between the encoding neural network and the decoding neural network; the neural encoder-decoder pair has been adapted such that the decoding neural network provides an estimated outer codeword symbol for an input outer codeword symbol by training the neural encoder-decoder pair using a training data set which comprises a plurality of outer codewords determined from a plurality of input messages by an outer code encoder. Each outer codeword symbols of the plurality of outer codewords is used as an input to the encoding neural network.

The training data set comprising the outer codewords determined from input messages by the outer code encoder as opposed to, e.g., a uniform sampling of input symbols, allows for specific optimization of the inner neural network code. With the resulting concatenated classic (non-neural) and neural network code, a channel code may be employed for data transfer which comprises a specific classic outer code for a given neural superchannel - comprising a chain of a neural network encoder, a channel, and neural network decoder - such that the blocklength and code dimension of the inner neural network code can be extended linearly with the parameters of the outer code, wherein the complexity increases algebraically.

Hence, encountering a very large number of parameters to be optimized can be avoided which, due to an exponential increase in the number of codewords arising with the code dimension, may be required for creating neural network codes for large blocklengths without the proposed code concatenation. In contrast, by the proposed code concatenation, a single code with a long blocklength may be obtained that may represent a low-complexity alternative to directly providing a classic code for long blocklengths. An improved channel code for error correction with a large blocklength is possible by using a concatenation scheme in which the decoding complexity increases only algebraically with a concatenated code blocklength, whereas the block error probability decreases exponentially. The concatenation scheme being adapted to the inner neural network code may improve the performance of the neural network code and allows for training with larger blocklengths and code rates by reducing the total decoding complexity and delay for large blocklengths.

By using one of the proposed outer codes, a high code-minimum-distance for given code blocklength and code dimension can be achieved. For example, Reed-Solomon (RS) codes are maximum distance separable (MDS) codes defined over a large Galois field. While the inner code may comprise a high error-correction capability and small code dimension, remaining errors (and possibly also erasures) may be corrected by a high-rate non-binary outer code with a low-complexity decoder. The employed outer codes, in particular RS codes, may protect against bursty errors caused by, e.g., memory effects in the noisy channel, thereby being especially advantageous for noisy channels with a channel memory that is less than the blocklength of the inner neural network code.

Within the context of the present disclosure, a superscript may denote a sequence of variables, e.g., $x^n = x_1, x_2, ..., x_i, ..., x_n$, and a subscript may denote a variable position in the sequence. Further, a boldface lower case letter, such as x, may represent a vector, in particular a vector of random variable realizations, with elements $x_i$, and a boldface upper case letter X may represent a matrix of realizations. $F_q$ denotes a Galois field with q elements, where q is a prime power. Within the context of the present disclosure, a range indicated by the phrase "between x and y" includes the boundary points x and y.

Within the context of the present disclosure, in case a quantity is used as an input to (output from) a neural network, the quantity may be an input to/of (output from) the neural network. The quantity may be a direct input (output) to the neural network, i.e., there may be no further intermediate quantity that is determined from the quantity (from which the quantity is determined) and which is subsequently (previously) used as input to (output from) the neural network. The quantity may also be an indirect input to (output from) the neural network. In particular, each outer codeword symbol may be a direct or an indirect input to the encoding neural network.

The training may comprise optimizing an encoding parameter vector of the encoding neural network (inner code encoder) and/or optimizing a decoding parameter vector of the decoding neural network (inner code decoder). The encoding parameter vector may comprise a plurality of encoding weight matrices and/or a plurality of encoding bias vectors. Each of the encoding weight matrices and/or encoding bias vectors may be assigned to a layer of the encoding neural network. The decoding parameter vector may comprise a plurality of decoding weight matrices and/or a plurality of decoding bias vectors. Each of the decoding weight matrices and/or decoding bias vectors may be assigned to a layer of the decoding neural network. The encoding parameter vector and/or the decoding parameter vector may be determined by a gradient-descend method. The encoding neural network and the decoding neural network may, e.g., be trained alternatingly.

Training may be carried out using a loss function that is configured to minimize an error probability of the concatenated code. The loss function may be a categorical cross-entropy loss or a binary cross-entropy loss.

The training may comprise feedbacked neural learning, such as reinforcement learning, and/or mutual-information-estimation based neural learning and/or generative adversarial network (GAN) based learning. The neural encoder-decoder pair may correspond to an (over-complete) autoencoder, in particular with a noisy channel in between. Reinforcement learning may for example be carried out using a policy gradient method. The policy gradient method may comprise perturbing an encoding neural network output for determining a gradient estimate in order to train the encoding neural network.

Employing the outer code may reduce a required amount of channel simulations, especially for high signal-to-noise ratios as compared to end-to-end neural network code constructions, since the error correction capability of the outer (classic) code may already provide a coarse target symbol error probability for the small inner neural network code, given a (compound) channel model.

Determining the training data set may comprise randomly sampling the plurality of input messages (having a fixed message length), in particular randomly determining a plurality of input messages, preferably with a fixed message length. The random determining may, e.g., comprise uniform random sampling. Depending on the data to be transmitted, different sets of input messages and/or different sampling distributions may also be employed. Determining the training data set may further comprise determining the plurality of outer codewords by encoding the plurality of input messages with the outer code encoder, yielding, in particular, each of the outer codeword symbols of the plurality of outer codewords. Each outer codeword symbol of each codeword of the plurality of outer codewords may be used as an input to the encoding neural network.

The training may comprise determining a plurality of binary vectors from the plurality of outer codeword symbols, preferably by one-hot encoding each of the plurality of outer codeword symbols (provided as an input to the encoding neural network). The plurality of binary vectors may also be determined from the plurality of outer codeword symbols by binary encoding each of the plurality of outer codeword symbols.

One-hot encoding may allow for improved error probability performance. One-hot-encoding techniques can in particular be employed for training when using small inner code dimensions, e.g., 6 or 8.

The training may further comprise determining a plurality of normalized vectors from a plurality of encoder output vectors by subjecting each of the plurality of encoder output vectors to a power constraint, preferably a block power constraint.

In particular, the plurality of normalized vectors may be determined by subtracting a mean value from each of the plurality of encoder output vectors and subsequently dividing by the square root of a variance value.

The training may comprise determining a plurality of noisy vectors from a plurality of intermediate vectors by subjecting the plurality of intermediate vectors, preferably each of the plurality of intermediate vectors, to noise, wherein the plurality of intermediate vectors may result from the encoding neural network. The plurality of intermediate vectors and/or the plurality of noisy vectors may be used as an input of the decoding neural network. The plurality of intermediate vectors may be subjected to noise via the nonlinear and/or noisy channel.

Each intermediate vector may be one of the plurality of encoder output vectors. Each intermediate vector may also be one of the plurality of normalized vectors

In particular, the training may comprise determining the plurality of noisy vectors from the plurality of normalized vectors by subjecting the plurality of normalized vectors, preferably each of the plurality of normalized vectors, to noise.

The training may also comprise determining the plurality of noisy vectors from the plurality of encoder output vectors, by subjecting the plurality of encoder output vectors, preferably each of the plurality of encoder output vectors, to noise.

The noise may be independent and identically distributed (i.i.d.). The noise may have a Gaussian distribution, in particular with zero mean and/or a variance proportional to a noise power per positive frequency. The noise may be additive, in particular additive white Gaussian noise (AWGN). The noise may also have any other distribution associated with a communication model. In particular, the noise may comprise Rayleigh channel noise and/or bursterror channel noise.

The training may comprise performing a plurality of training trials, for each of which the noise comprises a different one of a plurality of noise levels. For example, in a first training trial, the noise may have a first noise level and in a second training trial, the noise may have a second noise level different from the first noise level. Further, in a third training trial, the noise may have a third noise level different from the first and the second noise level. An entire training set may be processed for each training trial.

The plurality of noise levels may comprise energy per bit to noise power spectral density ratios (signal-to-noise ratio per bit values) $E_b/N_0$ from 1.0 dB to 3.5 dB and/or from 4.0 dB to 7.5 dB and/or from 8.0 dB to 15.0 dB. Preferably, the plurality of noise levels may comprise signal-to-noise ratio per bit values $E_b/N_0$ from 2.5 dB to 3.5 dB and/or from 4.5 dB to 5.5 dB and/or from 9.5 dB to 10.5 dB. More preferably, the plurality of noise levels may comprise signal-to-noise ratio per bit values $E_b/N_0$ from 2.9 dB to 3.1 dB and/or from 4.9 dB to 5.1 dB and/or from 9.9 dB to 10.1 dB. $E_b$ denotes the average signal energy per information bit and $N_0$ denotes the noise power per positive-frequency.

At least one of the plurality of noise levels may be due to one of an AWGN channel, a Rayleigh fast fading channel, and a bursty channel. The plurality of noise levels may for example be selected such that a symbol error rate between 0.001 and 0.1, preferably between 0.005 and 0.05, is achieved.

The training may comprise determining a plurality of decoder output vectors from the plurality of noisy vectors by applying the decoding neural network to the plurality of noisy vectors.

Determining the plurality of decoder output vectors may further comprise applying a softmax function to the decoding neural network output, in particular for the categorical cross-entropy loss or a sigmoid function for the binary cross-entropy loss. Determining the plurality of decoder output vectors may further comprise using a maximum of a softmax function output and/or a maximum of a sigmoid function output, preferably as a decision threshold for discarding symbols, for example by setting a decoder output vector component to be an erasure symbol based on being below a predefined confidence threshold of the highest value in the softmax function output and/or the highest value in the sigmoid function output.

The estimated message may be determined from the plurality of noisy vectors and/or decoding neural network outputs by using an outer code decoder, preferably a list decoder, which more preferably uses soft information obtained from the decoding neural network. The list decoder may for example be a Guruswami-Sudan list decoder for RS codes.

The outer code decoder may be an errors-only decoder that may preferably correct only outer codeword symbol errors. The outer code decoder may also be an errors-and-erasures decoder that may preferably correct both outer codeword symbol errors and symbol erasures. The errors-and-erasures decoder may require a thresholding step for the decoding neural network comprising setting a neural decoder output vector component to an erasure symbol based on the minimum confidence level being below a predefined symbol confidence threshold. The decoding neural network output may take any value between 0 and 1. The symbol confidence threshold for the highest value of the softmax function output and/or the sigmoid function output may for example be 0.5 for the softmax value and an appropriate value for the sigmoid function output. Confidence values may vary in correspondence with the specific signal-to-noise characteristic of the system and may accordingly be optimized.

The outer codeword symbols may be fed serially or in parallel as input to the encoding neural network.

For example, a single encoding neural network may be used serially/sequentially by providing only one encoding neural network (e.g., by hardware implementation), in particular one neural encoder-decoder pair. Alternatively, multiple copies of the (same) encoding neural network, in particular, multiple copies of the (same) neural encoder-decoder pair may be provided such that each of the copies of the encoding neural network (in particular, of the neural encoder-decoder pair) receives one of the outer codeword symbols. Each of the copies of the encoding neural network (or the neural encoder-decoder pair) may have the same encoding neural network parameters (and/or decoding neural network parameters). In case of a single encoding neural network, a more compact and cost-efficient design may be achieved. In case of multiple copies, computations may be parallelized so that the total computation time may be reduced.

The number of (implemented) encoding neural networks may be equal to the number of decoding neural networks. Alternatively, the number of encoding neural networks may be different from (e.g., greater or less than) the number of decoding neural networks. The complexity for encoding and decoding may thus be optimized separately since the power constraint may be applied to an entire codeword (of length $n_1 \cdot n_2$) in between the encoding neural network(s) and decoding neural network(s), which may result in a complete separation of neural encoding and decoding.

The outer code may have an outer code dimension between 127 and 4095, preferably 223, and/or the inner code has an inner code dimension between 3 and 27, preferably between 6 and 12, more preferably 4 or 8. The outer code may have an outer blocklength between 127 and 4096, preferably 255, and/or the inner code has an inner blocklength between 8 and 24, preferably 12.

The inner code dimension may for example be smaller than the outer code dimension. The inner code dimension may be the binary logarithm of the number of possible outer codeword symbols.

The outer codeword symbols may be non-binary. The number of possible outer codeword symbols (which is the cardinality of the set of possible symbols) may be 8, 9, 16, 27, 32, 64, 81, 128, 256, 512 or 1024. Each possible outer codeword symbol may be represented as a binary or ternary string that may be given as an input sequence to the encoding neural network. The outer codeword symbols may in particular be from a Galois field with a field size being a power of two with an integer exponent greater than one. An input size of the encoding neural network may be equal to said integer exponent.

The inner code may be binary, i.e., the inner code symbols may be binary. Alternatively, the outer codeword symbols may be binary and/or the inner code symbols may be non-binary.

Each of the outer codeword symbols from each of the plurality of outer codewords may be used as an input to the encoding neural network, in particular after representing the symbol as a binary or ternary string.

The outer codeword symbols (of different codewords of the plurality of outer codewords) may be interleaved by an interleaver, preferably before being used as an input to the encoding neural network. The outer codeword symbols from the plurality of outer codewords used (when a plurality of transmissions is combined) as an input to the encoding neural network may thus result from different codewords of the plurality of outer codewords.

Analogously, the inner neural decoder output vectors (from the different codewords of the plurality of outer codewords) may be de-interleaved by a de-interleaver, in particular before being used as an input to the outer code decoder. By interleaving the outer codewords, protection against burst errors and robustness to channel model changes may be improved. The number of outer codewords whose symbols are interleaved with each other may for example be equal to the blocklength of the outer code.

The interleaver may be a block interleaver, preferably a row-column block interleaver.

The interleaving may comprise determining an interleaving matrix for the different codewords of the plurality of outer codewords, preferably for a number of outer codewords that is equal to the blocklength of the outer code. Determining the interleaving matrix may comprise filling matrix rows (or matrix columns) of the interleaving matrix with the outer codeword symbols of each codeword of the plurality of outer codewords. In other words, each of the matrix rows (or of the matrix columns) of the interleaving matrix comprises the outer codeword symbols of one of the outer codewords. The interleaving may further comprise determining the outer codeword symbols from the plurality of outer codewords used (for one pass) as an input to the inner encoding neural network from matrix columns (or matrix rows) of the interleaving matrix.

The neural encoder-decoder pair may have been adapted and/or trained in a third data processing unit. The third data processing unit may be different from the first data processing unit and/or the second data processing unit. The neural encoder-decoder pair may also have been adapted and/or trained in the first data processing unit and/or the second data processing unit.

The neural encoder-decoder pair may have been adapted and/or trained before and/or independently from determining, in the first data processing unit, the codeword to be sent. The neural encoder-decoder pair may have been adapted and/or trained before and/or independently from receiving, in the second data processing unit, the noisy version of the codeword transmitted via the communication channel. The neural encoder-decoder pair may have been adapted and/or trained before and/or independently from determining the estimated message from the noisy version of the codeword by using the channel code.

The first data processing unit may be a first data processing device. The second data processing unit may be a second data processing device. The third data processing unit may be a third data processing device. The first data processing unit and the second data processing unit may also be part of a common data processing device, such as a coded data storage device. The third data processing unit may also be a part of the common data processing device. At least one or each of the data processing devices may, e.g., be a computer. At least one of or each of the data processing units may comprise a (volatile and/or non-volatile) memory.

The (physical) communication channel may comprise a wired channel and/or a wireless channel. The communication channel may for example comprise at least one of an optical fiber, a Wi-Fi channel, a radio channel or a storage device channel.

Determining the codeword from the message using the channel code may comprise encoding the message with the channel code. Determining the codeword may in particular comprise determining a first intermediate (outer) codeword by encoding the message (to the first intermediate codeword) using the outer code. Determining the codeword may further comprise encoding the first intermediate codeword using the inner code (in particular, using the encoding neural network), which preferably has been adapted/trained using the training data set.

Sending (transmitting) the codeword via the communication channel may comprise sending/transmitting the codeword from the first data processing unit, in particular by a first transceiver unit. The codeword emitted via/to the communication channel may yield a noisy version, which is received at the second data processing unit. The noisy version of the codeword may for example be yielded due to noise in the communication channel. The codeword and the noisy version of the codeword may be different from each other or, depending on the noise power/level, be the same. The codeword may be stored in the first data processing unit/device. The noisy version of the codeword may be stored in the second data processing unit/device.

Receiving the noisy version of the codeword may comprise receiving the noisy version of the codeword by a second transceiver unit of the second data processing unit. Determining the estimated message from the noisy version of the codeword using the channel code may comprise decoding the noisy version of the codeword with the channel code. Determining the estimated message may in particular comprise determining a second intermediate codeword by decoding the noisy version of the codeword using the inner code (in particular, using the decoding neural network), which preferably has been adapted/trained using the training data set. Determining the estimated message may further comprise decoding the second intermediate codeword (to the estimated message) using the outer code.

The first intermediate codeword may be interleaved with further first intermediate codewords from further messages, preferably before being encoded using the inner code. The second intermediate codeword may be de-interleaved, preferably before being decoded using the outer code.

The embodiments described above in connection with the methods for data transfer via a communication channel may be provided correspondingly for the systems for data transfer via a communication channel. The decoding described for the second data processing unit may also correspondingly be carried out in the first data processing unit. The encoding described for the first data processing unit may also correspondingly be carried out in the second data processing unit.

## Description of further embodiments

In the following, embodiments are described with reference to figures.

FIG. 1 shows a graphical representation of a system for data transfer via a communication channel.
FIG. 2 shows a graphical representation of a neural encoder-decoder pair of an inner neural network code together with an outer code input/output.
FIG. 3 shows a graphical representation of a channel code comprising an outer code concatenated with an inner code.

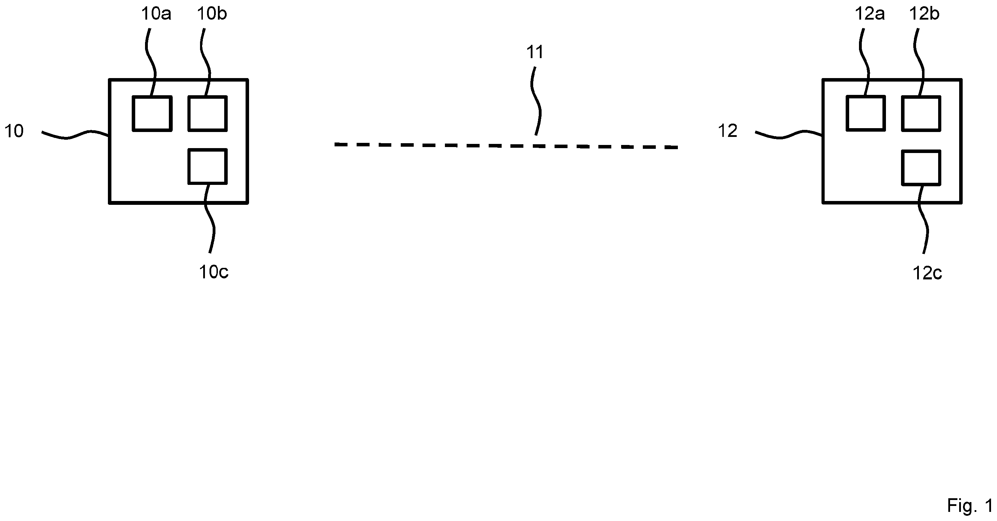

In Fig. 1, a graphical representation of a system for data transfer via a communication channel 11 is shown. The system may comprise a first data processing unit 10. The first data processing unit 10 may be a first data processing device with a first processor 10a, a first memory unit 10b, and a first transceiver unit 10c. The first transceiver unit 10c is configured to send/emit and/or receive signals via the communication channel 11. The communication channel 11 may or may not be part of the system.

Additionally or alternatively, the system may comprise a second data processing unit 12. The second data processing unit 12 may be a second data processing device with a second processor 12a, a second memory unit 12b, and a second transceiver unit 12c. The second transceiver unit 12c is configured to send/emit and/or receive signals via the communication channel 11.

Further, a third data processing unit (not necessarily part of the system) may be provided (not shown). The third data processing unit may be a third data processing device with a third processing unit, a third memory unit and, optionally, a third transceiver unit.

For data transfer between the first data processing unit 10 and the second data processing unit 12, a codeword is determined in the first data processing unit 10 from an (initial) message using a channel code. In particular, a first intermediate codeword is determined from the message by encoding the message with an outer code. Further, the codeword is determined from the first intermediate codeword by encoding the first intermediate codeword using an inner code. The inner code is a neural network code comprising a neural encoder-decoder pair with a channel between them that has been adapted to provide a reliable estimate of the transmitted message by training the neural encoder-decoder pair.

Subsequently, the codeword is sent from the first data processing unit 10 to the second data processing unit 12 via the communication channel 11, resulting in a noisy version of the codeword, which is received at the second data processing unit 12. From the noisy version of the codeword, an estimate of the message is determined in the second data processing unit 12 using the decoder of the channel code. In particular, a second intermediate codeword is determined from the noisy version of the codeword by decoding the noisy version of the codeword using the decoder of the (trained) inner code. Further, the estimated message is determined from the second intermediate codeword by decoding the second intermediate codeword using the decoder of the outer code. In case of successful error correction, the (initial) message and the estimated message coincide and one can say that there was no block error.

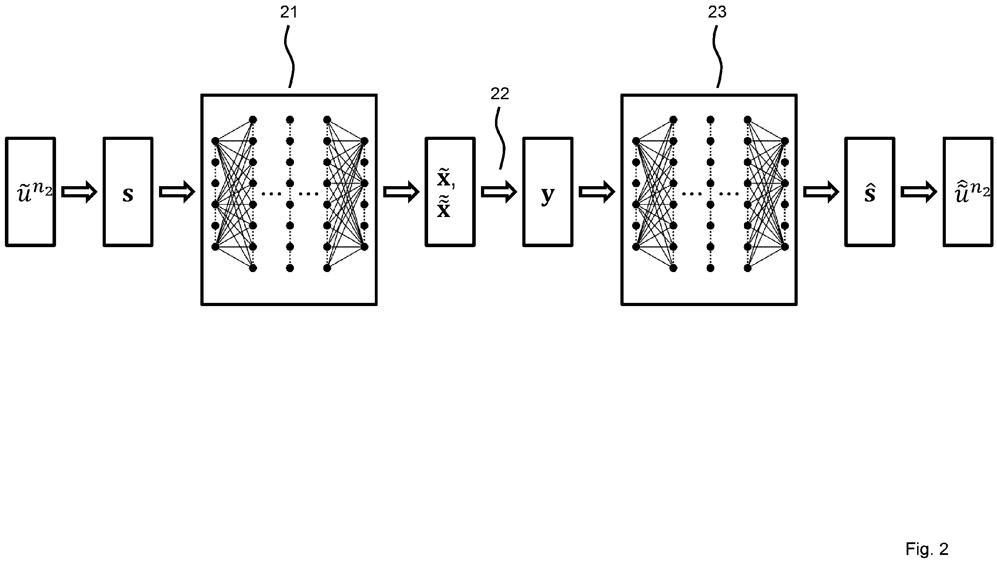

In Fig. 2, a graphical representation of a neural encoder-decoder pair with a channel between them that are encoders and decoders of an inner neural network code is shown together with an outer code input/output. Training the encoder-decoder pairs may be carried out as follows. Steps as a part of the training may model and/or correspond to respective steps for transmission of messages / data transfer.

A training data set may be determined by randomly sampling (e.g., according to a uniform distribution for all message symbols) a plurality of input messages with a fixed message length $k_2$, where $k_2$ is a positive natural number. Subsequently, a plurality of outer codewords / outer code sequences $\tilde{u}^{n_2}$, where $n_2$ is a positive natural number that is larger than or equal to $k_2$, is determined by encoding the plurality of input messages with an outer code encoder.

Each symbol of the outer codeword $\tilde{u}^{n_2}$ may be represented as a binary vector $s \in F_2^{2^{k_1}}$, where $k_1$, where $k_1$ is a positive natural number. Each binary vector s is determined by one-hot encoding one of the plurality of outer codeword symbols of a codeword. The outer code may for example be a Reed-Solomon code. The outer code is not a neural network code (i.e., the outer code is a "classic code").

Subsequently, an encoder output vector $\widetilde{x} \in \mathbb{R}^{n_1}$, where $n_1$ is a positive natural number, is determined from each binary vector s by applying a (parametrized) encoding function $f_\Theta$ which represents an encoding neural network (inner code encoder) 21 as a part of an $(n_1, k_1)$ neural network code. The encoding function $f_\Theta$ comprises a plurality of affine maps $F_1, ..., F_L$ and non-linear activation functions $\sigma_1, ..., \sigma_{L-1}$ such that the binary vector s is mapped to $\tilde{x}$ by $\tilde{x} = f_\Theta(s) = F_L(\sigma_{L-1}(F_{L-1}(.. \sigma_1(F_1(s))...)))$. Each affine map $F_l$ represents an l-th hidden layer of the encoding neural network 21 and comprises an (encoding) weight matrix $W_l$ and an (encoding) bias vector $b_l$. Hence, the encoding parameter vector $\Theta$ to be determined during training can be written as $\Phi = (W_l, b_l, ..., W_L, b_L)$. Each of the non-linear activation functions $\sigma_l, ..., \sigma_{L-1}$ may for example be the rectified linear unit (ReLU) activation function or any of its variants, including Leaky ReLU, randomized leaky ReLU, parametric leaky ReLU, or newer variants such as (exponential linear unit) ELU or scaled ELU. Other activation functions such as, e.g., the softplus function may also be provided. The number of encoder hidden layers L of the encoding neural network may for example be between 1 and 10, preferably be 2.

The encoding parameter vector $\Theta$ may, e.g., be determined by minimizing an empirical loss $\frac{1}{m} \sum_{i=1}^{m} l\big(f_\Theta(s_i), f(s_i)\big)$, wherein m denotes a number of samples (batch size), l denotes a loss function, for example a categorical cross-entropy loss and f denotes a function that is to be approximated. The loss function takes as input the input values of the encoding neural network and the output values of the decoding neural network. The loss function therefore calculates how far, in cross-entropy terms, the neural decoder output is from the neural encoder input.

Next, a normalized vector $\widetilde{\widetilde{x}}$ is determined from each encoder output vector $\check{x}$ by normalizing the encoder output vector $\tilde{x}$ via $\widetilde{\widetilde{x}} = \frac{(\widetilde{x} - \mu_{\tilde{x}})}{\sigma_{\widetilde{x}}}$ with mean $\mu_{\tilde{x}}$ and variance $\sigma_{\tilde{x}}^2$. This normalization may ensure that a block power constraint is satisfied. The random determining of the plurality of input messages results in a corresponding distribution of encoder output vectors $\check{x}$.

From each normalized vector $\widetilde{\widetilde{x}}$, a noisy vector **y** is sampled. This corresponds to the normalized vectors $\widetilde{\widetilde{x}}$ passing through a non-linear channel and/or noisy channel 22. The nonlinear/noisy channel 22 may simulate the (physical) communication channel 11. For example, independent and identically distributed (i.i.d.) noise according to a Gaussian distribution with zero mean and variance $\sigma^2 = \frac{N_0}{2}$ may be added to each normalized vector $\widetilde{\widetilde{x}}$. This represents an additive white Gaussian noise (AWGN) channel. Different noise models may be employed as well.

Subsequently, a (neural) decoder output vector $\hat{s} \in [0,1]^{2^{k_1}}$ is determined from each noisy vector y by applying a decoding function $g_{\Theta'}$, which represents a decoding neural network (inner code decoder) 23, and subsequently applying, e.g., a softmax function. Via the softmax function, the decoder output vector $\hat{s}$ is restricted to values between 0 and 1, for every element of the one-hot encoded input vector, where all elements sum to 1. Due to these properties, the values of the decoder output vector $\hat{s}$ can be regarded as confidence values that a certain input element was active (i.e., has a 1), while all other input elements are non-active (zero). The index of the element with the largest confidence value represents the estimated symbol. Moreover, if the largest confidence value of a certain decoder output falls below a certain threshold, the symbol transmission is discarded by flagging the symbol as erasure.

The decoding function $g_{\Theta'}$ comprises a plurality of (decoding) affine maps $G_1, ..., G_{L'}$ and (decoding) non-linear activation functions $\sigma_1', ..., \sigma_{L'-1}'$ such that the noisy vector y is mapped to $g_{\Theta'}(y) = G_{L'}\left(\sigma_{L'-1}'\left(G_{L'-1}'\big(...\sigma_1'(G_1(y)...)\big)\right)\right)$. Each decoding affine map $G_l$ represents an l-th (decoder) hidden layer of the decoding neural network 23 and comprises a (decoding) weight matrix $W_l'$ and a (decoding) bias vector $b_l'$. Hence, the decoder parameter vector $\Theta'$ to be determined during training can be written as

$\Theta' = (W'_1, b'_1, ..., W'_L, b'_L)$. Each of the decoder non-linear activation functions $\sigma'_1, ..., \sigma'_{L-1}$ may for example be the rectified linear unit activation function or any of its variants, including Leaky ReLU, randomized leaky ReLU, parametric leaky ReLU, or newer variants such as (exponential linear unit) ELU or scaled ELU. Other activation functions such as, e.g., the softplus function may also be provided. The number of decoder hidden layers L' may for example be between 1 and 10, preferably be 2.

The decoder output vector $\hat{s}$ can be interpreted as a vector of probabilities in which the j-th element is the estimated probability that the j-th outer codeword symbol was transmitted ($\tilde{J} \in \{1,2, ..., 2^{k_1}\}$).

From all neural decoder output vectors $\hat{s}$ via $\tilde{\tilde{u}}^{k_1} = argmax_j \hat{s}_j$, an outer code sequence estimate is obtained.

The decoder parameter vector $\Theta'$ may be determined by, e.g., a categorical cross-entropy loss, in particular, $-\sum_{j=1}^{2^{k_1}} s_{\tilde{j}} \log(\hat{s}_{\tilde{j}}) = -\log(\hat{s}_{\tilde{j}})$. For optimizing the decoder parameter vector $\Theta'$, the loss may be averaged over the batch size m, resulting in an empirical loss $-\frac{1}{m}\sum_{i=1}^{m} \log(\hat{s}_{\tilde{j}})_i$ and used in conjunction with an optimizer. The optimizer may for example comprise stochastic gradient descent or Adam with Nesterov momentum (NAdam).

The neural encoder-decoder pair is optimized over the outer code sequences. In particular, the neural encoder-decoder pair may be adapted/trained such that for input outer code sequences, corresponding estimated outer code sequences are provided and the loss function is minimized by the neural encoder-decoder pair. Thus, also for each input message an estimated message may be provided.

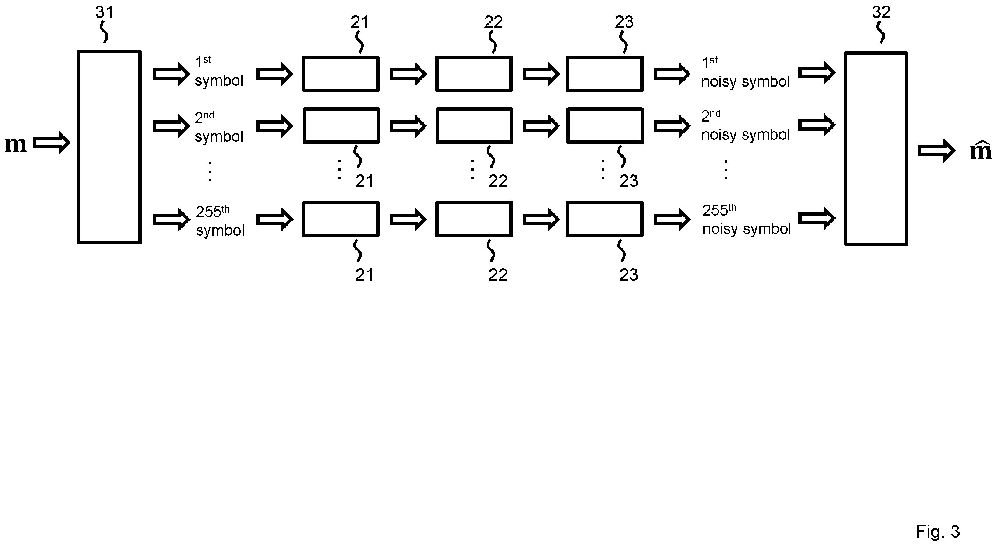

Fig. 3 shows a graphical representation of a channel code comprising an outer code concatenated with an inner code. The outer code is an $(n_2, k_2)$ RS code with outer code blocklength $n_2 = 255$, outer code dimension (message length) $k_2 = 223$, and outer codeword symbols from $F_q$ with number of outer codeword symbols q = 256, i.e., from $\{0, 1, ..., 255\}$. It is noted that $n_2 = 255 = q - 1$. The inner code is an $(n_1, k_1)$ neural network code with inner code blocklength $n_1 = 12$ and inner code dimension $k_1 = \log_2 q = 8$.

An input message m with message length $k_2 = 223$ and comprising 223 input symbols is encoded by an outer code encoder (here: RS encoder) 31 to an outer codeword (here: RS codeword) with blocklength $n_2 = 255$, i.e., the RS codeword comprises 255 outer codeword symbols (here: RS symbol). Each outer codeword symbol can be represented by $\log_2 256 = 8$ bits, allowing for each outer codeword symbol to indicate one of $2^8 = 256$ possible outer codeword symbol value assignments. In case of one-hot encoding, each outer codeword symbol is represented by a binary vector s with 256 bits, in particular by one of (0,...0,1), (0,...,0,1,0), ..., (0,1,0,...,0), and (1,0,...,0).

Since each outer codeword symbol can be represented by 8 bits, which is equal to the inner code dimension $k_1$, each outer codeword symbol constitutes an inner code input and each outer codeword symbol can then be used as an input of the (same) encoding neural network 21, i.e., the encoding neural network 21 is used $n_2 = 255$ times for each outer codeword. The encoding neural network 21 respectively outputs (binary) encoder output vectors $\tilde{x}$, each of which is represented by 12 bits, corresponding to the inner code blocklength being $n_1 = 12$. By respectively passing through the noisy channel 22, 255 noisy vectors $y$, each comprising 12 bits, are obtained. Each of the noisy vectors $y$ subsequently is given as an input to the (same) decoding neural network 23, respectively yielding one of 255 noisy (outer codeword) symbols (that correspond to a noisy RS codeword symbol), each of which can be represented by $k_l = 8$ bits. The 255 noisy outer codeword symbols (corresponding to a block with blocklength $n_2 = 255$) are subsequently fed into an outer code decoder (RS decoder) 32, yielding an estimate $\hat{m}$ of the input message $m$ with length $k_2 = 223$ and comprising 223 output symbols that are equal to the 223 symbols of the input message $m$.

Robustness and protection against burst errors can be improved by employing an interleaver (not shown in Fig. 3) between the outer code encoder 31 and the encoding neural networks 21, as well as a corresponding de-interleaver between the decoding neural networks 23 and the outer code decoder 32.

The interleaver may for example be a row-column block interleaver. To this end, an $n_2 \times n_2$ interleaver matrix is determined from $n_2$ outer codewords (respectively stemming from $n_2$ input messages m) such that each interleaver matrix row comprises the $n_2 = 255$ outer codeword symbols of each of the $n_2$ outer codewords. For each pass of outer codeword symbols as an input to the encoding neural network 21, the interleaver outputs one column comprising 255 outer codeword symbols of the interleaver matrix. This action is reversed by the deinterleaver before the outer code decoder 32.

Using an outer high-rate RS code with an errors-only decoder as part of the outer code decoder 32, considerable gains in terms of block error probabilities / BLER as compared to mere neural encoder-decoder pairs for an additive white Gaussian noise channel / AWGN may be achieved. An errors-and-erasures decoder may be provided by applying a thresholding algorithm to the softmax outputs of the decoding neural network 23 and determining a symbol as erased based on being below a confidence threshold, which may yield further BLER gains.

Simulations for the AWGN channel at 3.75 dB of signal-to-noise ratio per bit value $E_b/N_0$ show that the BLER of a comparative plain neural network code with code dimension 4 and blocklength 7 is equal to $1.4 \times 10^{-2}$, while the BLER of the proposed channel code, with code dimension $8 \cdot 223$ and blocklength $12 \cdot 255$, is equal to $1.05 \times 10^{-3}$. This illustrates the fundamental gains from the proposed type of channel codes since the comparative plain neural network code and the channel code comprise approximately same code rates $((223 \cdot 8)/(255 \cdot 12) \approx 4/7)$. While plain polar codes and plain LDPC (low-density-parity check) codes may result in smaller BLER values for the AWGN channel at the same $E_b/N_0$ level, these codes may not be robust to changes in the channel parameters and channel model. The proposed channel code thus also provides advantages for, e.g., fading and bursty channels.

It is to be noted that the structure of Fig. 3 is only an example. By way of example, the number of processed symbols may be larger or smaller than 255. Furthermore, in various aspects of this disclosure, the number of symbols each encoding neural network 21 (and decoding neural network 23) may receive and process and output may be larger than one. In other words, each encoding neural network 21 and each decoding neural network 23 may receive and process and output one or more symbols.

Further, the proposed method allows for employing higher blocklengths, in particular above 256, as well as higher code rates with respect to general neural encode-decoder code designs. The latter are generally more restricted due to a huge training and computation complexity of encoding and decoding, which corresponds to neural networks becoming huge. With the proposed method, high blocklengths and code rates can be achieved together with a small complexity, which may be even lower than the decoding complexity of polar and LDPC codes.

**Claims**

1. A method for data transfer via a communication channel (11), comprising:

    determining, in a first data processing unit (10), a codeword from a message using a channel code and sending the codeword via the communication channel (11),
    wherein the channel code comprises an outer code concatenated with an inner code;
    wherein the outer code is one of a Reed-Solomon code, a folded Reed-Solomon code, a twisted Reed-Solomon code, and a generalized Reed-Solomon code;
    wherein the inner code is a neural network code comprising a neural encoder-decoder pair, which includes an encoding neural network (21) and a decoding neural network (23);
    wherein a nonlinear channel and/or a noisy channel (22) is arranged between the encoding neural network (21) and the decoding neural network (23); and
    wherein the neural encoder-decoder pair has been adapted such that the decoding neural network (23) provides an estimated outer codeword symbol for an input outer codeword symbol by training the neural encoder-decoder pair using a training data set which comprises a plurality of outer codewords determined from a plurality of input messages by an outer code encoder (31),
    wherein each outer codeword symbol of the plurality of outer codewords is used as an input to the encoding neural network (21).

2. The method according to claim 1,
    wherein the training comprises determining a plurality of binary vectors from the outer codeword symbols, preferably by one-hot encoding each of the outer codeword symbols.

3. The method according to any one of the preceding claims,
    wherein the training comprises determining a plurality of normalized vectors from a plurality of encoder output vectors by subjecting each of the plurality of encoder output vectors to a power constraint.

4. The method according to one of the preceding claims,

    wherein the training comprises determining a plurality of noisy vectors from a plurality of intermediate vectors by subjecting the plurality of intermediate vectors to noise,
    wherein the plurality of intermediate vectors result from the encoding neural network (21) and are used as an input of the decoding neural network (23).

5. The method according to claim 4,
    wherein the training comprises performing a plurality of training trials, for each of which the noise comprises a different one of a plurality of noise levels.

6. The method according to claim 4 or 5,

wherein the training comprises determining a plurality of decoder output vectors from the plurality of noisy vectors by applying the decoding neural network (23) to the plurality of noisy vectors.

7. The method according to one of the preceding claims, further comprising:
determining an estimated message from the plurality of noisy vectors by using an outer code decoder, preferably a list decoder.

8. The method according to one of the preceding claims,
wherein the outer codeword symbols are fed serially or in parallel as input to the encoding neural network (21).

9. The method according to one of the preceding claims,
wherein the outer code has an outer code dimension between 127 and 1023, preferably 223, and/or the inner code has an inner code dimension between 3 and 27, preferably 4 or 8.

10. The method according to one of the preceding claims,
wherein the outer codeword symbols are non-binary.

11. The method according to one of the preceding claims,
wherein the outer codeword symbols of different codewords of the plurality of outer codewords are interleaved by an interleaver, preferably before being used as input to the encoding neural network (21).

12. The method according to claim 11,
wherein the interleaver is a block interleaver, preferably a row-column block interleaver.

13. A method for data transfer via a communication channel (11), comprising:

receiving, in a second data processing unit (12), a noisy version of a codeword that has been transmitted via the communication channel (11) and determining an estimated message from the noisy version of the codeword using a channel code,
wherein the channel code comprises an outer code concatenated with an inner code;
wherein the outer code is one of a Reed-Solomon code, a folded Reed-Solomon code, a twisted Reed-Solomon code, and a generalized Reed-Solomon code;
wherein the inner code is a neural network code comprising a neural encoder-decoder pair which includes an encoding neural network (21) and a decoding neural network (23);
wherein a nonlinear channel and/or a noisy channel (22) is arranged between the encoding neural network (21) and the decoding neural network (23); and
wherein the neural encoder-decoder pair has been adapted such that the decoding neural network (23) provides an estimated outer codeword symbol for an input outer codeword symbol by training the neural encoder-decoder pair using a training data set which comprises a plurality of outer codewords determined from a plurality of input messages by an outer code encoder (31),
wherein each outer codeword symbol of the plurality of outer codewords is used as an input to the encoding neural network (21).

14. A system for data transfer via a communication channel (11), the system comprising a first data processing unit (10) and being configured to:

determine, in the first data processing unit (10), a codeword from a message using a channel code and send the codeword via the communication channel (11),
wherein the channel code comprises an outer code concatenated with an inner code;
wherein the outer code is one of a Reed-Solomon code, a folded Reed-Solomon code, a twisted Reed-Solomon code, and a generalized Reed-Solomon code;
wherein the inner code is a neural network code comprising a neural encoder-decoder pair which includes an encoding neural network (21) and a decoding neural network (23);
wherein a nonlinear channel and/or a noisy channel (22) is arranged between the encoding neural network (21) and the decoding neural network (23); and
wherein the neural encoder-decoder pair has been adapted such that the decoding neural network (23) provides an estimated outer codeword symbol for an input outer codeword symbol by training the neural encoder-decoder pair using a training data set which comprises a plurality of outer codewords determined from a plurality of input messages by an outer code encoder (31),
wherein each outer codeword symbols of the plurality of outer codewords is used as an input to the encoding neural network (21).

15. A system for data transfer via a communication channel (11), the system comprising a second data processing unit (12) and being configured to:

receive, in the second data processing unit (12), a noisy version of a codeword that has been transmitted via the communication channel (11) and determine an estimated message from the noisy version of the codeword using a channel code,
wherein the channel code comprises an outer code concatenated with an inner code;
wherein the outer code is one of a Reed-Solomon code, a folded Reed-Solomon code, a twisted Reed-Solomon code, and a generalized Reed-Solomon code;
wherein the inner code is a neural network code comprising a neural encoder-decoder pair which includes an encoding neural network (21) and a decoding neural network (23);
wherein a nonlinear channel and/or a noisy channel (22) is arranged between the encoding neural network (21) and the decoding neural network (23); and
wherein the neural encoder-decoder pair has been adapted such that the decoding neural network (23) provides an estimated outer codeword symbol for an input outer codeword symbol by training the neural encoder-decoder pair using a training data set which comprises a plurality of outer codewords determined from a plurality of input messages by an outer code encoder (31),
wherein each outer codeword symbols of the plurality of outer codewords is used as an input to the encoding neural network (21).

## Patentansprüche

1. Verfahren zur Datenübertragung über einen Kommunikationskanal (11), aufweisend:

Ermitteln, in einer ersten Datenverarbeitungseinheit (10), eines Codeworts aus einer Nachricht unter Verwendung eines Kanalcodes und Senden des Codeworts über den Kommunikationskanal (11),
wobei der Kanalcode einen mit einem inneren Code verketteten äußeren Code aufweist;
wobei der äußere Code einer der folgenden ist: ein Reed-Solomon-Code, ein gefalteter Reed-Solomon-Code, ein twisted Reed-Solomon-Code und ein verallgemeinerter Reed-Solomon-Code;
wobei der innere Code ein Neuronales-Netzwerk-Code ist, welcher ein neuronales Codierer-Decodierer-Paar aufweist, welches ein codierendes neuronales Netzwerk (21) und ein decodierendes neuronales Netzwerk (23) aufweist;
wobei ein nichtlinearer Kanal und/oder ein verrauschter Kanal (22) zwischen dem codierenden neuronalen Netzwerk (21) und dem decodierenden neuronalen Netzwerk (23) angeordnet ist; und
wobei das neuronale Codierer-Decodierer-Paar derart angepasst wurde, dass das decodierende neuronale Netzwerk (23) ein geschätztes äußeres Codewortsymbol für ein eingegebenes äußeres Codewortsymbol bereitstellt, indem es das neuronale Codierer-Decodierer-Paar unter Verwendung eines Trainingsdatensatzes trainiert, welcher eine Vielzahl von äußeren Codewörtern aufweist, welche aus einer Vielzahl von Eingangsnachrichten von einem Äußeren-Code-Codierer (31) ermittelt wurden,
wobei jedes äußere Codewortsymbol der Vielzahl von äußeren Codewörtern als Eingabe für das codierende neuronale Netzwerk (21) verwendet wird.

2. Das Verfahren gemäß Anspruch 1,
wobei das Training das Ermitteln einer Vielzahl von binären Vektoren aus den äußeren Codewortsymbolen aufweist, vorzugsweise durch One-Hot-Codierung jedes der äußeren Codewortsymbole.

3. Das Verfahren gemäß einem der vorstehenden Ansprüche,
wobei das Training das Ermitteln einer Vielzahl von normalisierten Vektoren aus einer Vielzahl von Codierer-Ausgangsvektoren aufweist, indem jeder der Vielzahl von Codierer-Ausgangsvektoren einer Leistungsbeschränkung unterworfen wird.

4. Das Verfahren gemäß einem der vorstehenden Ansprüche,

wobei das Training das Ermitteln einer Vielzahl von verrauschten Vektoren aus einer Vielzahl von Zwischenvektoren aufweist, indem die Vielzahl von Zwischenvektoren Rauschen ausgesetzt wird,
wobei die Vielzahl von Zwischenvektoren aus dem codierenden neuronalen Netzwerk (21) resultiert und als Eingabe des decodierenden neuronalen Netzwerks (23) verwendet wird.

5. Das Verfahren gemäß Anspruch 4,
wobei das Training das Durchführen einer Vielzahl von Trainingsversuchen aufweist, für welche jeweils das Rauschen einen unterschiedlichen Rauschpegel einer Vielzahl von Rauschpegeln aufweist.

6. Das Verfahren gemäß Anspruch 4 oder 5,
wobei das Training das Ermitteln einer Vielzahl von Decodierer-Ausgangsvektoren aus der Mehrzahl von verrauschten Vektoren durch Anwenden des decodierenden neuronalen Netzwerks (23) auf die Vielzahl von verrauschten Vektoren aufweist.

7. Das Verfahren gemäß einem der vorstehenden Ansprüche, ferner aufweisend:
Ermitteln einer geschätzten Nachricht aus der Vielzahl von verrauschten Vektoren unter Verwendung eines Äußeren-Code-Codierers, vorzugsweise eines Listen-Decodierers.

8. Das Verfahren gemäß einem der vorstehenden Ansprüche,
wobei die äußeren Codewortsymbole seriell oder parallel als Eingabe für das codierende neuronale Netzwerk (21) eingegeben werden.

9. Das Verfahren gemäß einem der vorstehenden Ansprüche,
wobei der äußere Code eine äußere Code-Dimension zwischen 127 und 1023, vorzugsweise 223, und/oder der innere Code eine innere Code-Dimension zwischen 3 und 27, vorzugsweise 4 oder 8, hat.

10. Das Verfahren gemäß einem der vorstehenden Ansprüche,
wobei die äußeren Codewortsymbole nicht binär sind.

11. Das Verfahren gemäß einem der vorstehenden Ansprüche,
wobei die äußeren Codewortsymbole verschiedener Codewörter der Vielzahl von äußeren Codewörtern von einem Verschachteler verschachtelt werden, vorzugsweise bevor sie als Eingabe für das codierende neuronale Netzwerk (21) verwendet werden.

12. Das Verfahren gemäß Anspruch 11,
wobei der Verschachteler ein Block-Verschachteler, vorzugsweise ein Zeilen-Spalten-Block- Verschachteler ist.

13. Verfahren zur Datenübertragung über einen Kommunikationskanal (11), aufweisend:

Empfangen, in einer zweiten Datenverarbeitungseinheit (12), einer verrauschten Version eines Codeworts, welches über den Kommunikationskanal (11) übertragen wurde, und Ermitteln einer geschätzten Nachricht aus der verrauschten Version des Codeworts unter Verwendung eines Kanalcodes,
wobei der Kanalcode einen mit einem inneren Code verketteten äußeren Code aufweist
wobei der äußere Code einer der folgenden ist: ein Reed-Solomon-Code, ein gefalteter Reed-Solomon-Code, ein twisted Reed-Solomon-Code und ein verallgemeinerter Reed-Solomon-Code;
wobei der innere Code ein Neuronales-Netzwerk-Code ist, welcher ein neuronales Codierer-Decodierer-Paar aufweist, welches ein codierendes neuronales Netzwerk (21) und ein decodierendes neuronales Netzwerk (23) aufweist;
wobei ein nichtlinearer Kanal und/oder ein verrauschter Kanal (22) zwischen dem codierenden neuronalen Netzwerk (21) und dem decodierenden neuronalen Netzwerk (23) angeordnet ist; und
wobei das neuronale Codierer-Decodierer-Paar derart angepasst wurde, dass das decodierende neuronale Netzwerk (23) ein geschätztes äußeres Codewortsymbol für ein eingegebenes äußeres Codewortsymbol bereitstellt, indem es das neuronale Codierer-Decodierer-Paar unter Verwendung eines Trainingsdatensatzes trainiert, welcher eine Vielzahl von äußeren Codewörtern aufweist, welche aus einer Vielzahl von Eingangsnachrichten von einem Äußeren-Code-Kodierer (31) ermittelt wurden,
wobei jedes äußere Codewortsymbol der Vielzahl von äußeren Codewörtern als Eingabe für das codierende neuronale Netzwerk (21) verwendet wird.

**14.** System zur Datenübertragung über einen Kommunikationskanal (11), wobei das System eine erste Datenverarbeitungseinheit (10) aufweist und eingerichtet ist zum:

Ermitteln, in der ersten Datenverarbeitungseinheit (10), eines Codeworts aus einer Nachricht unter Verwendung eines Kanalcodes und Senden des Codeworts über den Kommunikationskanal (11),
wobei der Kanalcode einen mit einem inneren Code verketteten äußeren Code aufweist;
wobei der äußere Code einer der folgenden ist: ein Reed-Solomon-Code, ein gefalteter Reed-Solomon-Code, ein twisted Reed-Solomon-Code und ein verallgemeinerter Reed-Solomon-Code;
wobei der innere Code ein Neuronales-Netzwerk-Code ist, welcher ein neuronales Codierer-Decodierer-Paar aufweist, welches ein codierendes neuronales Netzwerk (21) und ein decodierendes neuronales Netzwerk (23) aufweist;
wobei ein nichtlinearer Kanal und/oder ein verrauschter Kanal (22) zwischen dem codierenden neuronalen Netzwerk (21) und dem decodierenden neuronalen Netzwerk (23) angeordnet ist; und
wobei das neuronale Codierer-Decodierer-Paar derart angepasst wurde, dass das decodierende neuronale Netzwerk (23) ein geschätztes äußeres Codewortsymbol für ein eingegebenes äußeres Codewortsymbol bereitstellt, indem es das neuronale Codierer-Decodierer-Paar unter Verwendung eines Trainingsdatensatzes trainiert, welcher eine Vielzahl von äußeren Codewörtern aufweist, welche aus einer Vielzahl von Eingangsnachrichten von einem Äußeren-Code-Kodierer (31) ermittelt wurden,
wobei jedes äußere Codewortsymbol der Vielzahl von äußeren Codewörtern als Eingabe für das codierende neuronale Netzwerk (21) verwendet wird.

**15.** System zur Datenübertragung über einen Kommunikationskanal (11), wobei das System eine zweite Datenverarbeitungseinheit (12) aufweist und eingerichtet ist zum:

Empfangen, in der zweiten Datenverarbeitungseinheit (12), einer verrauschten Version eines Codeworts, welches über den Kommunikationskanal (11) übertragen wurde, und Ermitteln einer geschätzten Nachricht aus der verrauschten Version des Codeworts unter Verwendung eines Kanalcodes,
wobei der Kanalcode einen mit einem inneren Code verketteten äußeren Code aufweist
wobei der äußere Code einer der folgenden ist: ein Reed-Solomon-Code, ein gefalteter Reed-Solomon-Code, ein verdrehter Reed-Solomon-Code und ein verallgemeinerter Reed-Solomon-Code;
wobei der innere Code ein Neuronales-Netzwerk-Code ist, welcher ein neuronales Codierer-Decodierer-Paar aufweist, welches ein codierendes neuronales Netzwerk (21) und ein decodierendes neuronales Netzwerk (23) aufweist;
wobei ein nichtlinearer Kanal und/oder ein verrauschter Kanal (22) zwischen dem codierenden neuronalen Netzwerk (21) und dem decodierenden neuronalen Netzwerk (23) angeordnet ist; und
wobei das neuronale Codierer-Decodierer-Paar derart angepasst wurde, dass das decodierende neuronale Netzwerk (23) ein geschätztes äußeres Codewortsymbol für ein eingegebenes äußeres Codewortsymbol bereitstellt, indem es das neuronale Codierer-Decodierer-Paar unter Verwendung eines Trainingsdatensatzes trainiert, welcher eine Vielzahl von äußeren Codewörtern aufweist, welche aus einer Vielzahl von Eingangsnachrichten von einem Äußeren-Code-Kodierer (31) ermittelt wurden,
wobei jedes äußere Codewortsymbol der Vielzahl von äußeren Codewörtern als Eingabe für das codierende neuronale Netzwerk (21) verwendet wird.

**Revendications**

**1.** Procédé de transfert de données par l'intermédiaire d'un canal de communication (11), le procédé comprenant les étapes suivantes :

déterminer, dans une première unité de traitement de données (10), un mot de code à partir d'un message au moyen d'un code de canal, et envoyer le mot de code par l'intermédiaire du canal de communication (11),
le code de canal comprenant un code externe concaténé avec un code interne ;
le code externe étant un code parmi un code Reed-Solomon, un code Reed-Solomon plié, un code Reed-Solomon tordu et un code Reed-Solomon généralisé ;
le code interne étant un code de réseau neuronal comprenant une paire codeur-décodeur neuronal, qui comprend un réseau neuronal de codage (21) et un réseau neuronal de décodage (23) ;
un canal non linéaire et/ou un canal bruité (22) étant disposés entre le réseau neuronal de codage (21) et le réseau neuronal de décodage (23) ; et

la paire codeur-décodeur neuronal ayant été adaptée de telle sorte que le réseau neuronal de décodage (23) fournisse un symbole de mot de code externe estimé pour un symbole de mot de code externe d'entrée par apprentissage de la paire codeur-décodeur neuronal au moyen d'un ensemble de données d'apprentissage qui comprend une pluralité de mots de code externes déterminés à partir d'une pluralité de messages d'entrée par un codeur de code externe (31),

chaque symbole de mot de code externe de la pluralité de mots de code externes étant utilisé comme entrée dans le réseau neuronal de codage (21).

**2.** Procédé selon la revendication 1,
l'apprentissage comprenant de déterminer une pluralité de vecteurs binaires à partir des symboles de mots de code externes, de préférence par codage one-hot de chacun des symboles de mots de code externes.

**3.** Procédé selon l'une quelconque des revendications précédentes,
l'apprentissage comprenant de déterminer une pluralité de vecteurs normalisés à partir d'une pluralité de vecteurs de sortie de codeur en soumettant chacun de la pluralité de vecteurs de sortie de codeur à une contrainte de puissance.

**4.** Procédé selon l'une des revendications précédentes, dans lequel l'apprentissage comprend de déterminer une pluralité de vecteurs bruités à partir d'une pluralité de vecteurs intermédiaires en soumettant la pluralité de vecteurs intermédiaires à du bruit,
la pluralité de vecteurs intermédiaires résultant du réseau neuronal de codage (21) et étant utilisés comme entrée du réseau neuronal de décodage (23).

**5.** Procédé selon la revendication 4,
l'apprentissage comprenant d'effectuer une pluralité d'essais d'apprentissage, pour chacun desquels le bruit comprend un niveau de bruit différent parmi une pluralité de niveaux de bruit.

**6.** Procédé selon la revendication 4 ou la revendication 5,
l'apprentissage comprenant de déterminer une pluralité de vecteurs de sortie de décodeur à partir de la pluralité de vecteurs bruités par application du réseau neuronal de décodage (23) à la pluralité de vecteurs bruités.

**7.** Procédé selon l'une des revendications précédentes, comprenant en outre l'étape suivante :
déterminer un message estimé à partir de la pluralité de vecteurs bruités au moyen d'un décodeur de code externe, de préférence un décodeur de liste.

**8.** Procédé selon l'une des revendications précédentes, dans lequel les symboles de mots de code externes sont alimentés en série ou en parallèle en tant qu'entrée dans le réseau neuronal de codage (21).

**9.** Procédé selon l'une des revendications précédentes, dans lequel le code externe a une dimension de code externe comprise entre 127 et 1023, de préférence 223, et/ou le code interne a une dimension de code interne comprise entre 3 et 27, de préférence 4 ou 8.

**10.** Procédé selon l'une des revendications précédentes, dans lequel les symboles de mots de code externes sont non binaires.

**11.** Procédé selon l'une des revendications précédentes, dans lequel les symboles de mots de code externes de différents mots de code de la pluralité de mots de code externes sont entrelacés par un entrelaceur, de préférence avant d'être utilisés comme entrée dans le réseau neuronal de codage (21).

**12.** Procédé selon la revendication 11,
dans lequel l'entrelaceur est un entrelaceur en blocs, de préférence un entrelaceur en blocs rangée-colonne.

**13.** Procédé de transfert de données par l'intermédiaire d'un canal de communication (11), le procédé comprenant les étapes suivantes :

recevoir, dans une deuxième unité de traitement de données (12), une version bruitée d'un mot de code transmis par l'intermédiaire du canal de communication (11), et déterminer un message estimé à partir de la version bruitée du mot de code au moyen d'un code de canal,
le code de canal comprenant un code externe concaténé avec un code interne ;

le code externe étant un code parmi un code Reed-Solomon, un code Reed-Solomon plié, un code Reed-Solomon tordu et un code Reed-Solomon généralisé ;

le code interne étant un code de réseau neuronal comprenant une paire codeur-décodeur neuronal, qui comprend un réseau neuronal de codage (21) et un réseau neuronal de décodage (23) ;

un canal non linéaire et/ou un canal bruité (22) étant disposés entre le réseau neuronal de codage (21) et le réseau neuronal de décodage (23) ; et

la paire codeur-décodeur neuronal ayant été adaptée de telle sorte que le réseau neuronal de décodage (23) fournisse un symbole de mot de code externe estimé pour un symbole de mot de code externe d'entrée par apprentissage de la paire codeur-décodeur neuronal au moyen d'un ensemble de données d'apprentissage qui comprend une pluralité de mots de code externes déterminés à partir d'une pluralité de messages d'entrée par un codeur de code externe (31),

chaque symbole de mot de code externe de la pluralité de mots de code externes étant utilisé comme entrée dans le réseau neuronal de codage (21).

14. Système de transfert de données par l'intermédiaire d'un canal de communication (11), le système comprenant une première unité de traitement de données (10) et étant configuré pour :

déterminer, dans la première unité de traitement de données (10), un mot de code à partir d'un message au moyen d'un code de canal, et envoyer le mot de code par l'intermédiaire du canal de communication (11),

le code de canal comprenant un code externe concaténé avec un code interne ;

le code externe étant un code parmi un code Reed-Solomon, un code Reed-Solomon plié, un code Reed-Solomon tordu et un code Reed-Solomon généralisé ;

le code interne étant un code de réseau neuronal comprenant une paire codeur-décodeur neuronal, qui comprend un réseau neuronal de codage (21) et un réseau neuronal de décodage (23) ;

un canal non linéaire et/ou un canal bruité (22) étant disposés entre le réseau neuronal de codage (21) et le réseau neuronal de décodage (23) ; et

la paire codeur-décodeur neuronal ayant été adaptée de telle sorte que le réseau neuronal de décodage (23) fournisse un symbole de mot de code externe estimé pour un symbole de mot de code externe d'entrée par apprentissage de la paire codeur-décodeur neuronal au moyen d'un ensemble de données d'apprentissage qui comprend une pluralité de mots de code externes déterminés à partir d'une pluralité de messages d'entrée par un codeur de code externe (31),

chaque symbole de mot de code externe de la pluralité de mots de code externes étant utilisé comme entrée dans le réseau neuronal de codage (21).

15. Système de transfert de données par l'intermédiaire d'un canal de communication (11), le système comprenant une deuxième unité de traitement de données (12) et étant configuré pour :

recevoir, dans la deuxième unité de traitement de données (12), une version bruitée d'un mot de code transmis par l'intermédiaire du canal de communication (11), et

déterminer un message estimé à partir de la version bruitée du mot de code au moyen d'un code de canal,

le code de canal comprenant un code externe concaténé avec un code interne ;

le code externe étant un code parmi un code Reed-Solomon, un code Reed-Solomon plié, un code Reed-Solomon tordu et un code Reed-Solomon généralisé ;

le code interne étant un code de réseau neuronal comprenant une paire codeur-décodeur neuronal, qui comprend un réseau neuronal de codage (21) et un réseau neuronal de décodage (23) ;

un canal non linéaire et/ou un canal bruité (22) étant disposés entre le réseau neuronal de codage (21) et le réseau neuronal de décodage (23) ; et

la paire codeur-décodeur neuronal ayant été adaptée de telle sorte que le réseau neuronal de décodage (23) fournisse un symbole de mot de code externe estimé pour un symbole de mot de code externe d'entrée par apprentissage de la paire codeur-décodeur neuronal au moyen d'un ensemble de données d'apprentissage qui comprend une pluralité de mots de code externes déterminés à partir d'une pluralité de messages d'entrée par un codeur de code externe (31),

chaque symbole de mot de code externe de la pluralité de mots de code externes étant utilisé comme entrée dans le réseau neuronal de codage (21).

Fig. 1

EP 4 333 310 B1

Fig. 2

EP 4 333 310 B1

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 11387848 B1

### Non-patent literature cited in the description

- **S. LIN** ; **D. J. COSTELLO**. Error control coding. Prentice Hall, 2001, vol. 2
- **E. ARIKAN**. *IEEE Trans. Inf. Theory*, 2009, vol. 55 (7), 3051-3073
- **I. TAL** ; **A. VARDY**. *IEEE Trans. Inf. Theory*, 2015, vol. 61 (5), 2213-2226
- **Y. JIANG et al.** *Conf. Neural Inf. Process. Sys.*, 2019, vol. 32, 1-19
- **J. CLAUSIUS et al.** *Int. Symp. Topics Coding, Montreal*, 2021, 1-5
- Serial vs. parallel turbo-autoencoders and accelerated training for learned channel codes.. **CLAUSIUS, JANNIS et al.** 2021 11th International Symposium on Topics in Coding (ISTC). IEEE, 2021
- Turbo autoencoder with a trainable interleaver.. **CHAHINE, KARL et al.** ICC 2022-IEEE International Conference on Communications. IEEE, 2022
- On deep learning-based channel decoding.. **GRUBER, TOBIAS et al.** 2017 51st annual conference on information sciences and systems (CISS). IEEE, 2017